Europäisches Patentamt

(19) European Patent Office

Office européen des brevets

(11) Publication number: **0 149 415**

**A2**

(12) # EUROPEAN PATENT APPLICATION

(21) Application number: **84710036.9**

(22) Date of filing: **15.12.84**

(51) Int. Cl.⁴: **C 23 F 4/00**
**H 01 L 21/31**

(30) Priority: **30.12.83 US 567031**

(43) Date of publication of application:
**24.07.85 Bulletin 85/30**

(84) Designated Contracting States:
**DE FR GB**

(71) Applicant: **International Business Machines Corporation**
**Old Orchard Road**
**Armonk, N.Y. 10504(US)**

(72) Inventor: **Chen, Lee**
**2 Vincent Road Poughkeepsie**
**New York 12603(US)**

(72) Inventor: **Mathad, Gangadhara Swami**
**5 Spurway Poughkeepsie**
**New York 12603(US)**

(74) Representative: **Kreidler, Eva-Maria, Dr. rer. nat.**
**Schönaicher Strasse 220**
**D-7030 Böblingen(DE)**

(54) **Reactive plasma process for etching chromium films with high chromium oxide and glass impurity content.**

(57) A thick layer of chromium containing $Cr_2O_3$/CrO and glass impurities therein is etched in a glow discharge in a low pressure ambient atmosphere of a chlorine-containing gas, oxygen and trace amounts of C and F constituents. In a preferred embodiment the C and F constituents are provided by coating the wall of the etching chamber with Teflon and carbon tetrachloride is the chlorine-containing gas.

EP 0 149 415 A2

REACTIVE PLASMA PROCESS FOR ETCHING CHROMIUM FILMS
WITH HIGH CHROMIUM OXIDE AND GLASS IMPURITY CONTENT

The invention relates to a glow discharge etching
process and more particularly to the etching of a
chromium film having a high concentration of chromium
oxide therein.

The etching of materials in a glass plasma formed from
reactive gases is known. These processes can generally
be divided into two types, termed plasma etching and
reactive ion etching. In plasma etching the workpiece
is placed in a chamber and a glow discharge is maintained by supplying RF energy to an electrode or electrodes which are external to the chamber. Typical power
levels are 100 to 400 watts at 13.5 MHz and pressures
are $6,65 \cdot 10^{-6}$ bar to a few mbar. In Example, this
apparatus and process is shown in U.S. patent 3,951,709.

A specific glow discharge etching process for chromium
is described in U.S. patent 4,229,247. In this patent,
chromium is selectively etched by exposing the chromium
to a glow discharge in a low pressure ambient atmosphere
of carbon tetrachloride, water and oxygen.

Normally, when a film of chromium is exposed to an
oxidizing atmosphere, it forms a relatively thin layer
having a thickness on the order of 3 to 4 nm in which
$CrO_2/CrO$ is present. Chromium films having a thin outer
layer in which $Cr_2O_3/CrO$ is present may be satisfactorily etched by the process described in the aforementioned U.S. patent 4,229,247.

However, when chromium films having a thicker layer,
for example up to 80 nm in which $Cr_2O_3/CrO$ and glass

FI 983 024

impurities are present, the aforementioned process does not etch such a film. Typically, these thick $Cr_2O_3/CrO$ and glass impurity containing layers are obtained when the chromium is in contact with a glass layer and the system is heated to an elevated temperature of the order of 1000°C. After sintering at 1000°C for a prolonged period of time, interdiffusion between the glass and chromium film takes place. This results in a high concentration of glass impurity penetrating the pores of the porous chromium film. In addition, oxygen diffusion into the chromium film causes the chromium to be oxidized. Due to the poor quality of the porous chromium film and the uncontrolled oxygen diffusion, the stoichiometry of the chromium oxide in the film is random. In view of the above, chromium films subjected to these sintering conditions are described as having a high chromium oxide ($Cr_2O_3/CrO$) and glass impurity content. Chromium films having a high chromium oxide and glass impurity content are not satisfactorily etched by the process described in the aforementioned U.S. patent 4,229,247.

The object of this invention is to provide an improved glow discharge etching process for thick chromium layers containing $Cr_2O_3/CrO$ and glass impurities.

The object of the invention is achieved by a process according to claim 1.

According to the invention a thick layer of chromium containing $Cr_2O_3/CrO$ and glass impurities therein is etched in a glow discharge in a low pressure ambient atmosphere of a chlorine-containing gas, oxygen and trace amounts of less than 4 % of C and F constituents. The chlorine-containing gas may be a chlorinated hydro-

FI 983 024

carbon gas such as $CCl_4$, $CCl_2F_2$ and the like. A preferred chlorine-containing gas is $CCl_4$ and a preferred concentration is 60 %. The C and F constituents may be provided by a fluorinated hydrocarbon such as $CF_4$ and the like or by coating the etching chamber wall with a fluorinated polymer such as Teflon (Trademark of E. I. du Pont de Nemours). In a preferred embodiment the C and F constituents are provided by coating the wall of the etching chamber with Teflon.

Other objects of this invention will be apparent from the following detailed description.

The etch process of the invention is carried out in a reactive ion etch system. The reactive ion etch system provides directional etching which results in straighter etch sidewalls so that better replication of the overlying resist pattern is obtained when compared to, for example, wet etching or plasma etching. The latter processes are non-directional in that the sidewalls under the resist mask are subject to etching. Suitable reactive ion etch tools are known in the art and a reactive ion etch system is schematically shown, for example, in Fig. 1 of U.S. patent 3,994,793. In the reactive ion etching system and process, the substrate to be etched is placed on a plate on a cathode which is connected to an RF power source so that it is electrically biased relative to a second electrode, or anode, which is parallel to and spaced from the cathode. The plate can be of various materials such as, for example, quartz, silicon, and aluminum. The reactive ion etch process is carried out at low pressures of from about $6{,}65 \cdot 10^{-6}$ bar to $6{,}65 \cdot 10^{-5}$ bar with pressures of $1{,}33 \cdot 10^{-5}$ to $3{,}99 \cdot 10^{-5}$ bar being preferred in the process of the invention. Power densities range from

FI 983 024

about 0.1 to 0.8 watts/cm$^2$, with a preferred power density being about 0.6 watts/cm$^2$ where organic resist masking layers are used, in order to avoid excessive loss of resist thickness. Auxiliary heating of the cathode plate to raise the temperature of the substrate can be employed in order to increase the etch rates. Because the photoresist tends to degrade at higher temperatures, a trade-off between etch rate and loss of resist thickness must be made.

The gas compositions suitable for the practice of the process of the invention are volatile polychlorinated organic materials, for example, $CCl_4$ and $C_2HCl_3$ which are mixed with oxygen and trace amounts of C and F constituents.

The concentration of the polychlorinated organic materials depends on which one is used. For example, with $CCl_4$, the range is from 30 to 50 percent by partial pressure, with a preferred concentration being about 40 %. Other polychlorinated organic materials that may be used are $C_2HCl_3$ and $CCL_2F_2$.

The concentration of the oxygen varies depending upon the polychlorinated organic material used. When $CCl_4$ is used, the oxygen concentration is from 50 to 70 percent.

The materials containing C and F radicals, for example, $CF_2$, $CF_3$, $CF_4$ radicals and the like are used in an amount that is less than 4 %. All of these percent concentrations are by partial pressure. The $CF_2$, $CF_3$ and $CF_4$ etc. radicals may be provided by introducing suitable gases such as $CF_4$. Another way of providing these fluorinated radicals in trace amounts of less than 4 % is to coat the inside wall of the etching chamber with a fluorine-containing polymer, for example, Teflon.

Certain volatile polychlorinated organic materials may provide a dual role in that they may also supply the C and F radicals. An example of such a material is $CCl_2F_2$ which is described in detail in Example II.

Example I

A three-layered film containing a top and bottom layer of chromium 80 nm thick and having a two-micron copper layer inbetween is positioned on a ceramic substrate. A glass insulator is in contact with the upper chromium layer and is subsequently heated. This results in the upper chromium layer having chromium oxide and glass impurities interspersed throughout the 80 nm thickness. In other words, the entire chromium layer has been oxidized to contain $Cr_2O_3$/CrO film and glass impurities scattered randomly throughout the layer.

The resultant oxidized chromium film containing the $Cr_2O_3$/CrO and glass impurities was etched in a chamber having a Teflon coating on the inside thereof. $CCl_4$ from a bottle source was passed through the chamber at a flow rate of 43 SCCM to provide a concentration of 40 % by partial pressure. Oxygen from a bottle having a flow rate of 9 SCCM was passed through the chamber to provide a concentration of 60 %. The total pressure in the system was 23 microns. The $CF_4$ concentration was a trace, that is, less than 4 %. The power density in the etching system was 0.6 $W/cm^2$ (total 300 W); DC bias developed was 700 volts; the etch rate was approximately 20 nm per minute. The etch time of the top oxidized chromium layer under these conditions was six minutes

FI 983 024

including the 50 % over etch. The copper layer under the top oxidized chromium layer was not etched under these conditions. There was no polymerization on the electrode or samples. There was no polymerization on the Teflon coating inside the etching chamber. There was a slight polymerization on the remaining grounded stainless steel surface.

Example II

An oxidized chromium film of the type described in Example 1 was placed in a stainless steel chamber having an aluminum top lid. There was no Teflon coating on the inside of the chamber. $CCl_2F_2$ from a bottle source and oxygen from a bottle source were passed through the chamber at a total gas flow of 20 SCCM. The gas pressure was $2,66 \cdot 10^{-5}$ bar and RF power density was $0.8 \text{ W/cm}^2$. The percentage of the $CCl_2F_2$ in the $CCl_2F_2:O_2$ mixture was varied as the chromium etch rate varied as shown in the following table.

| % $CCl_2F_2$ in $CCl_2F_2:O_2$ Mixture | Chromium Etch Rate nm/min |
|---|---|
| 20 | 2 |
| 40 | 16,8 |
| 45 | 16,0 |
| 50 | 16,8 |
| 60 | 16,0 |

The preferred concentration of $CCl_2F_2$ in the mixture is about 40 to 60 %. The etch rate will vary as the total gas flow and/or gas pressure is changed.

FI 983 024

**0149415**

Although preferred embodiments have been described, it is understood that numerous variations may be made in accordance with the principles of this invention.

FI 983 024

C L A I M S

1.  Process for selectively dry etching a thick
    chromium film having chromium oxide and glass
    impurities therein comprising the steps of

    exposing said chromium film in a low pressure
    ambient atmosphere comprising a mixture of a
    volatile polychlorinated organic material, oxygen
    and trace amounts of C and F constituents.

2.  Process as described in claim 1 whereby said
    trace amounts of the C and F constituents is
    less than 4 %.

3.  Process as described in claim 1 whereby said trace
    amounts of C and F constituents is provided by a
    gas taken from the group consisting of $CF_2$, $CF_3$,
    $CF_4$ and $CCl_2F_2$.

4.  Process as described in claim 1 whereby said trace
    amounts of C and F constituents is provided by a
    polymeric coating containing fluorine that is on
    the chamber wall.

5.  Process as described in claim 4 wherein said
    coating is Teflon.

6.  Process as described in claim 1 whereby said
    polychlorinated organic material is $CCl_4$.

7.  Process as described in claim 6 whereby the
    concentration of $CCl_4$ is 30 to 50 % by partial
    pressure.

FI 983 024

0149415

8. Process as described in claim 1 whereby said polychlorinated organic material is $CFCl_3$.

9. Process as described in claim 1 whereby said polychlorinated organic material is $CCl_2F_2$, said $CCl_2F_2$ providing trace amounts of C and F constituents.

FI 983 024